# EUROPEAN PATENT APPLICATION

(11) **EP 1 746 431 A1**
(43) Date of publication of application: **24.01.2007**
(21) Application number: 06002976.6
(22) Date of filing: 14.02.2006
(51) Int. Cl.: G01R 33/28

(54) **Magnetic resonance imaging apparatus with means for DNP hyperpolarization**

(30) Priority: 20.07.2005 JP 2005210080
(71) Applicant: HITACHI, LTD., Chiyoda-ku Tokyo 100-8280 (JP)
(72) Inventor: Osada, Akiko, Tokyo (JP); Yamamoto, Yukari Hitachi, Ltd. Int. Prop. Office, Chiyoda-ku Tokyo 100-8220 (JP); Taniguchi, Yo Hitachi, Ltd. Int. Property Office, Chiyoda-ku Tokyo 100-8220 (JP)
(74) Representative: Strehl Schübel-Hopf & Partner

(57) **Abstract**

The invention provides an MRI apparatus capable of using a static magnetic filed magnet provided therein as a magnet for polarization, and performing DNP therein without changing a construction of a conventional MRI apparatus. A DNP means placed in the MRI apparatus includes a sample tube (301), cooling units (304a-304c) for cooling and solidifying a sample in the sample tube, a microwave irradiating unit (302), and a metal tube (303). At least a member placed near an imaging space (five-gauss line) of the MRI apparatus is made of a nonmagnetic material, and a static magnetic field generating magnet of the MRI apparatus is used as a magnetic field applying means for applying a magnetic field to the sample for polarization. A contrast agent generated by the DNP can be immediately injected into a patient for imaging, so as to provide an image with high S/N.

## Description

### Background of the Invention

The present invention relates to a magnetic resonance imaging apparatus (hereinafter, referred to as an MRI apparatus) with a means for DNP hyperpolarization.

In an MRI apparatus, a nucleus of an atom constituting a part of a tissue of a subject placed in a static magnetic field is excited by applying a radio frequency magnetic field, and an NMR signal generated thereby is measured and imaged. Conventionally, S/N of the NMR signal has been improved by enhancing intensity of a static magnetic field magnet.

On the contrary, in recent years, it is proposed to enhance polarization of nuclear spin (which is called as hyperpolarization) by using a substance which is polarized outside a living body to improve S/N of the NMR signal (for example, see JP-A-9-173317, JP-A-2002-501006, a non-patent document ("Increase in signal-to-ratio of >10,000 times in liquid-state NMR", Jan H. Ardenkjaer-Larsen et al, PNAS vol.100, No. 18, 10158-10163, 2003) and the like). There are some methods for realizing the hyperpolarization. For example, in dynamic nuclear polarization (DNP) described in JP-A-2002-501006 and the above mentioned non-patent document, a free radical is added to a sample, and the sample is placed in a core of a magnet while being kept at a very low temperature. By irradiating a microwave in this solid state, electron spin polarization is transferred to the nuclear spin of 1H or the like, and the transferred polarization is further transferred to the nuclear spin of 13C or the like by cross polarization, so that a hyperpolarized contrast agent (13C contrast agent) is generated.

The contrast agent generated by this hyperpolarization is converted from the solid state into a liquid state, and thereafter the contrast agent is injected into the subject of the MRI and imaged, whereby an NMR signal with extremely high S/N can be obtained. The MRI utilizing the DNP is expected to provide a high quality image effective in diagnosis, without requiring subtraction in angiography and local perfusion imaging, for example.

The above mentioned non-Patent document discloses an apparatus for performing the DNP. This apparatus includes a sample holder for holding a container in which a sample is contained, a cooling unit for cooling the sample to keep it in the solid state, a magnet device for polarization, a microwave unit (which includes a microwave source for irradiating a microwave to the sample, a waveguide, etc.), and the like.

And now, when using the MRI apparatus for imaging with the contrast agent generated by the DNP, if the DNP device is provided outside the MRI apparatus, longitudinal relaxation time of the sample is significantly shortened because the static magnetic field is very low during the sample transportation. Therefore, it is preferable that the DNP device is possibly located near the subject, as long as the qualities of the MRI apparatus are not inhibited.

### Brief Summary of the Invention

In general, with respect to the MRI apparatuses utilizing the substances polarized outside a living body, for example, JP-A-9-173317 proposes an open MRI apparatus with magnets disposed above and below, in which a magnet for polarization is built into a support column connecting the upper and lower magnets. However, when providing the two kinds of magnets in the MRI apparatus, the design becomes complicated for uniformizing the static magnetic field space, which makes it difficult to create the magnets. In addition, JP-A-2002-501006 discloses that it is possible to use one magnet for the purposes of polarization and MR imaging, however, it does not disclose a concrete construction.

Accordingly, an object of the present invention is to provide an MRI apparatus capable of using a static magnetic field magnet included in the MRI apparatus as a magnet for polarization, and capable of performing DNP inside the apparatus without changing a construction of a conventional MRI apparatus.

An MRI apparatus of the present invention which solves the above problems includes a static magnetic field generating means for generating a static magnetic field in a space where a subject is to be placed, a magnetic field gradient generating means for generating a magnetic field gradient in the space, a transmitter means for applying a radio magnetic field to the subject, a receiver means for detecting a magnetic resonance signal generating from the subject, a signal processing means for reconstructing an image of the subject by using the magnetic resonance signal, and a hyperpolarization means for performing hyperpolarization processing of a substance to be injected into the subject. The hyperpolarization means includes a sample tube in which a sample is placed, a cooling unit for cooling and solidifying the sample in the sample tube, a magnetic field applying means for applying a magnetic field to the sample, and a microwave irradiating unit for irradiating a microwave to the sample. The magnetic field applying means is the above described static magnetic field generating means.

Further, the MRI apparatus of the present invention includes a means for installing the microwave irradiating unit, the sample tube and the cooling unit as an integral part in the static magnetic field space generated by the static magnetic field generating means.

At least a member placed in the static magnetic field space among members of the hyperpolarization means is formed of a nonmagnetic material.

Further, the MRI apparatus of the present invention preferably includes a means for picking up the sample tube from the hyperpolarization means and gripping the sample tube.

Further, in the MRI apparatus of the present invention, the hyperpolarization means may include a plurality of the sample tubes, and the cooling unit may include a sample tube supporting member made of a high thermal conductive material, and a gas passage formed inside and on an periphery of the supporting member for circulating a helium gas supplied from a helium gas supply source.

Other objects, features and advantages of the invention will become apparent from the following description of the embodiments of the invention taken in conjunction with the accompanying drawings.

Brief Description of the Several Views of the Drawings
Fig. 1 shows an appearance of an MRI apparatus according to a first embodiment of the present invention;
Fig. 2 shows a construction of the MRI apparatus of Fig. 1;
Fig. 3 shows a DNP device of the MRI apparatus according to the first embodiment;
Fig. 4 shows an operating state of the MRI apparatus according to the first embodiment;
Fig. 5 shows an operating state of the MRI apparatus according to the first embodiment;
Fig. 6 shows another example of the DNP device of the MRI apparatus according to the first embodiment;
Fig. 7 shows an MRI apparatus according to a second embodiment of the present invention;
Fig. 8 shows another embodiment of the DNP device; and
Fig. 9 shows still another embodiment of the DNP device.

### Brief Description of the Several Views of the Drawings

Hereinafter, embodiments of an MRI apparatus of the present invention will be described with reference to the drawings.

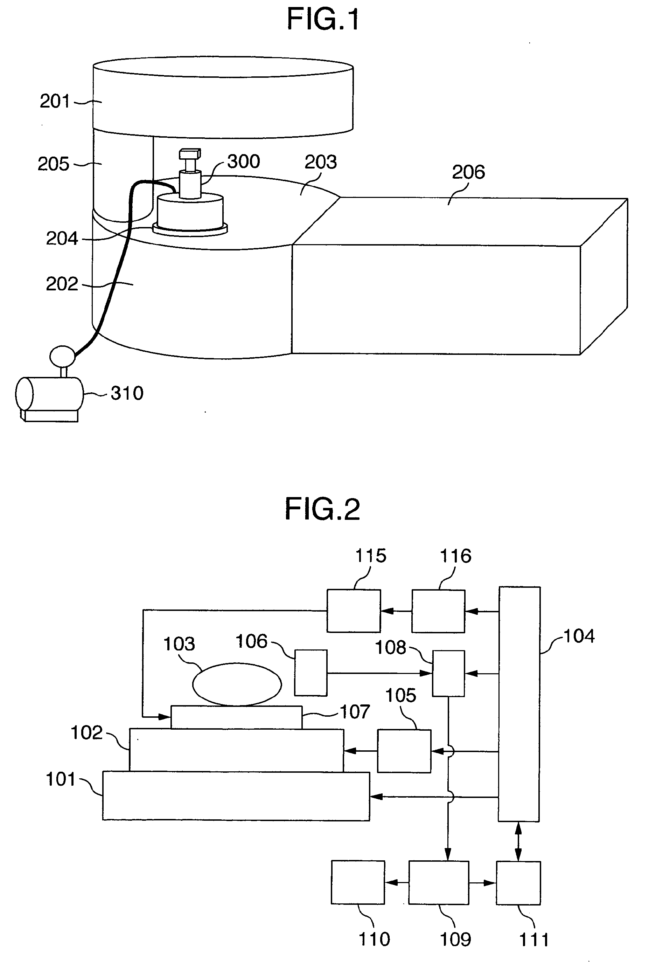

Fig. 1 is a view showing an appearance of an MRI apparatus according to a first embodiment of the present invention. The MRI apparatus is an open MRI apparatus in which a subject is placed in an opened space (a static magnetic field space), and a pair of magnets 201 and 202 are disposed above and below the static magnetic field space so as to put the static magnetic field space therebetween. The upper magnet 201 is supported by a support column 205, and is housed in a gantry 203 together with the lower magnet 202. In the case where the magnets 201 and 202 are superconducting magnets, a cryostat and the like are also housed in the gantry. A lower gantry is provided with a bed 206 for laying the subject thereon and inserting the subject in the static magnetic field space. Further, in the MRI apparatus of the present invention, a movable DNP hyperpolarization device 300 is placed in the static magnetic field space. The details of the DNP hyperpolarization device 300 will be described later.

Fig. 2 is a drawing showing an outline of an entire construction of the MRI apparatus, which includes a static magnetic field generating magnet 101, a gradient field coil 102 for applying a magnetic field gradient to this space, a transmitter coil 107 for irradiating a radio frequency magnetic field to a subject 103, a receiver coil 106 for receiving an NMR signal generated from the subject 103, a driving system for driving the magnet 101, the gradient field coil 102 and the transmitter coil 107, and a signal processing system for processing a signal from the receiver coil 106. Generally, the magnet 101 and the gradient field coil 102 are housed in the gantry 203. While Fig. 2 shows only one of each of the magnet 101 and the gradient field coil 102, in the case of the open MRI apparatus as shown in Fig. 1, a pair of the magnets 101 and a pair of the gradient field coils 102 are disposed above and below the static magnetic field space, respectively, so as to put the static magnetic field space therebetween.

The gradient field coil 102 is constituted by three gradient field coils having whose axes are orthogonal one another, and the three gradient field coils are respectively connected to a gradient field power supply 105. By driving the gradient field power supply 105 by a command from a sequencer 104, it is possible to provide the magnetic field gradient to the static magnetic field space in a desired direction. The transmitter coil 107 is connected via an RF pulse generator 116 and an RF power amplifier 115. The RF pulse is irradiated by amplifying the output of the RF pulse generator 116 by the command from the sequencer 104 and applying the output to the transmitter coil 107.

The receiver coil 106 is connected to a receiver 108 consisting of an A/D converter, an orthogonal phase detector and the like, and an NMR signal which is generated from the subject 103 and received by the receiver coil 106 is sampled and detected in the receiver 108, and transmitted to a computer 109. The NMR signal is subjected to a resampling process in the computer 109, and then subjected to processes of reconstructing an image and the like. The processed result (for example, an image) of the computer 109 is displayed on a display 110, and stored into a storage device 111 as needed.

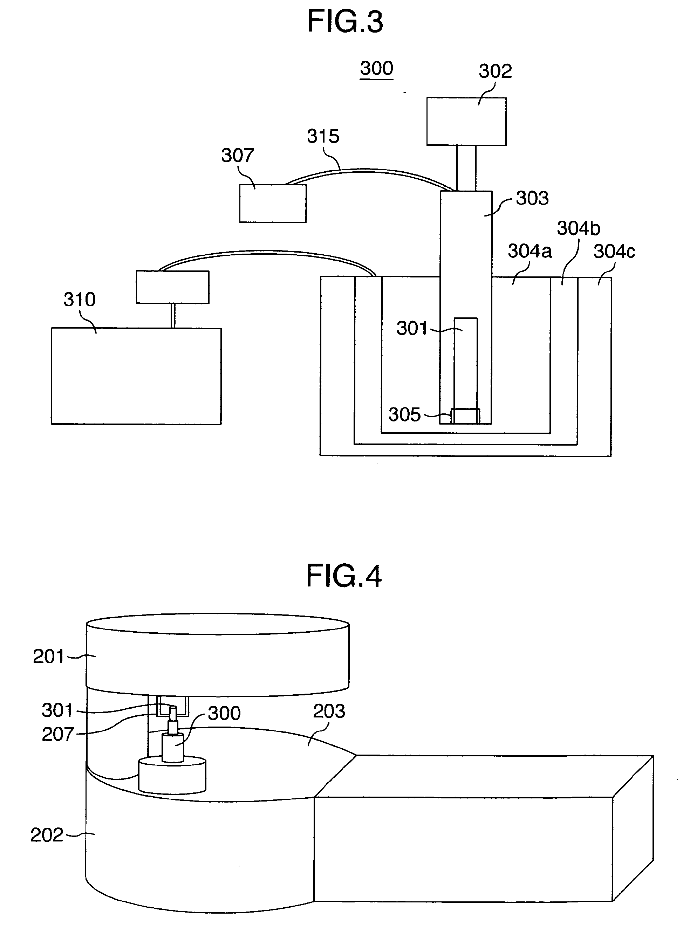

The DNP device 300 includes a sample tube 301 in which a substance (for example, a contrast agent) to be injected into the subject 103 is accommodated, a microwave irradiating device 302 for irradiating a microwave to the sample, a metal tube (including a waveguide) 303 by which the microwave is sealed, a cooling unit 304 (304a, 304b, 304c) for keeping the sample in a very low temperature state, and a heating unit 307 for heating the sample having been subjected to the DNP, as shown in Fig. 3.

The sample tube 301 contains, for example, the a 13C contrast agent to be injected into the subject as a sample. A free radical such as a nitro oxide for causing polarization transfer with 1H is mixed into the sample. The microwave irradiating device 302 is connected to the metal tube 303 via the waveguide so that a microwave (of the maximum output of 100 mW, for example) can be irradiated to the sample in the sample tube 301.

Further, an RF irradiating coil 305 for performing the cross polarization from 1H (hydrogen) to 13C (carbon) is placed outside the sample tube 301. The RF irradiating coil 305 uses two irradiating systems, which are a coil for irradiating a radio frequency magnetic field for locking a 1H spin system, and a coil for irradiating a radio frequency magnetic field H_{1c} (a radio frequency magnetic field which satisfies γ_{H}H_{1H} = γ_{C}H_{1C}) for synchronizing a 13C spin system with the frequency of the 1H spin system while locking the 1H spin system. As an RF irradiating coil 305 like this, a saddle coil can be used, for example.

The cooling unit consists of a liquid helium bath 304a, a vacuum bath 304b and a liquid nitrogen bath 304c in this order from an inner side thereof, and cools the sample inside the sample tube 301 to a very low temperature of the order of several K (Kelvins). The vacuum bath 304b is intended to shut off thermal conduction, is connected to an external vacuum pump 310 and is kept in a suitable vacuum degree. A holder which is formed from a fluororesin or the like for supporting the sample tube 301 is provided inside the liquid helium bath 304a, but is not shown.

The heating unit 307 is intended to change the state of the sample from the solid state where the sample is cooled by the cooling unit to a state where the sample can be injected into the subject. The heating unit 307 is provided with a tank for storing a physiologically allowable liquid such as water and physiological saline at a room temperature or heated, and a pipe 315 and the like for supplying the liquid to the sample tube 301.

Among the members constituting the DNP device 300, the members placed in the static magnetic field space or in the space near the static magnetic field (inside the five-gauss line), concretely, the sample tube 301, the microwave irradiation device 302, the metal tube 303 and the cooling units 304a to 304c are all made of a nonmagnetic material. As the nonmagnetic material, beryllium copper, stainless steel, titanium, aluminum, ceramics, plastic and the like are cited in concrete. The heating unit 307 is also made of the nonmagnetic material if it is placed within the five-gauss line.

The DNP device 300 as is constituted like this is placed in the static magnetic field space while the above described members constructed of the nonmagnetic material are made movable in an integrated state. In the embodiment shown in Fig. 1, a movable base seat 204 made of the nonmagnetic material is placed on an underside of the gantry, and the DNP device 300 is mounted on this base seat 204. Preferably, wheels are equipped on a undersurface of the base seat 204, and thereby the DNP device 300 can be moved to an optional position. The wheels may be attached to the DNP device 300 itself. By attaching the wheels, the DNP device 300 and the base seat 204 can be easily separated.

Further, the upper gantry is preferably equipped with a gripper 207 for taking out the sample tube 301 containing the sample having been hyperpolarized from the DNP device 300, as shown in Fig. 4. The gripper 207 may be any gripper as long as it includes an open-closeable gripping portion at its tip end, and a mechanism which makes the gripping portion extend and contract in at least one direction (for example, in a vertical direction), and can adopt a mechanism used for a general purpose manipulator. It is also preferable that the gripper 207 is made of a nonmagnetic material. Further, the gripper 207 is attached to the gantry via a link and an arm, so that the gripper 207 can be put into the static magnetic field space and evacuated to a position outside the static magnetic field space as needed.

The operation of the MRI apparatus with the DNP means in such a construction will be described.

First, the DNP device 300 is mounted on the base seat 204 placed in the gantry, the base seat 204 on which the DNP device 300 is mounted is moved as needed so as to be set at a predetermined place inside the static magnetic field space, and then the base seat 204 is removed. Since the static magnetic field used for DNP does not require high static field uniformity as required for imaging, the DNP device 300 can be set at a position slightly away from the center of an imaging area. Thus, it is possible to perform operations of injecting the contrast agent and the like without obstructing a space which the subject enters during imaging, even if the DNP device 300 remains being placed there.

Meanwhile, a sample (a 13C contrast agent) in which a predetermined chemical compound (which is to be a free radical) is uniformly mixed is put into the sample tube 301, this sample tube 301 is inserted into the sample holder in the cooling units 304a to 304c, and then the cooling unit is sealed while maintaining the condition where the holder and the metal tube are connected. In the fixed condition where the sample is cooled to a very low temperature by the cooling unit, a microwave is irradiated to the sample by the microwave irradiation device 302 via the metal pipe 303. The DNP is performed by irradiating the microwave to the sample placed in the strong magnetic field (the magnetic field generated by the static magnetic field magnets 201 and 202 in this case) and at the very low temperature, and 1H is hyperpolarized by performing DNP of electron spin of the sample having been cooled to be solidified. In this state, the radio frequency magnetic field is irradiated by the RF transmitter coil 305, and in the state where the 1H spin system is locked, the radio frequency magnetic field which satisfies γ_{H}H_{1H} = γ_{C}H_{1C} is irradiated. By the dipole-dipole interaction between 13C and 1H, it becomes possible to exchange energy between both spins, so that the polarization is shifted from 1H to 13C by cross polarization.

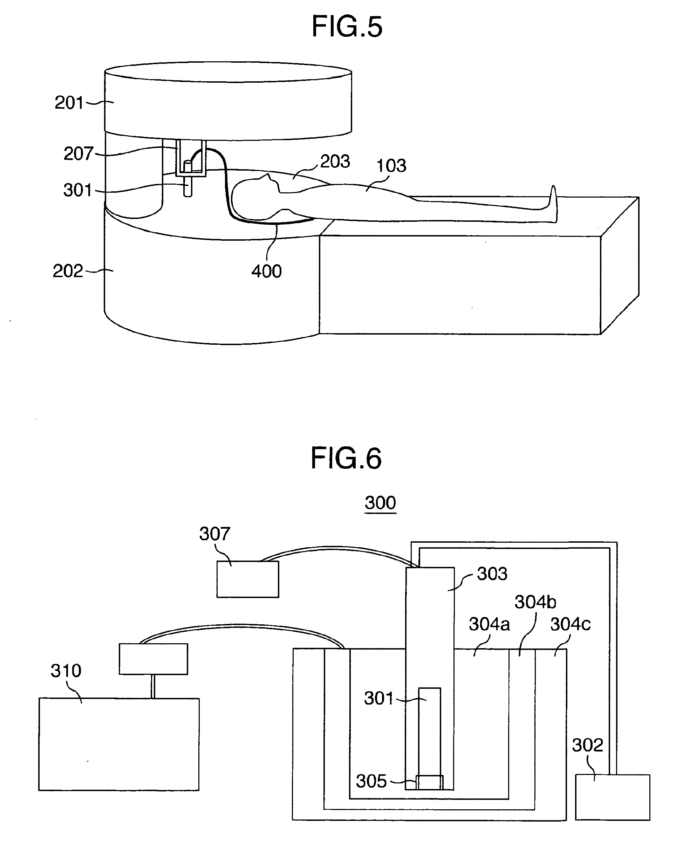

After the irradiation of the microwave is stopped, the seal of the cooling unit is released, the gripper 207 is moved to an upper portion of the cooling unit and operated so as to take out the sample tube 301 from the inside of the holder. Alternatively, the base seat 204 on which the cooling unit is placed is moved so as to be located just below the gripper 207. After the sample tube 301 is taken out from the holder by the gripper 207, a liquid inside the heating unit 307 is poured into the sample tube 301 to heat the solid sample to a (liquid) state capable of being injected into the subject. In this case, as shown in Fig. 5, the DNP device 300 except the sample tube 301 gripped by the gripper 207 is moved to a place outside the static magnetic field space or out of the imaging space as needed. A preparation for imaging the subject is performed together with the operation of heating the solid sample, the subject is placed into the imaging space in the gantry, and then the contrast agent is injected into the subject by a catheter 400 or the like. The heating unit 307 and the gripper 207 are evacuated from the static magnetic field space, and then the imaging by the MRI, more typically, angio imaging or perfusion imaging is started.

In this manner, according to this embodiment, the DNP can be performed inside the static magnetic field space of the MRI apparatus, and further, the generated contrast agent can be immediately used for imaging. Therefore, it is possible to prevent shortening of the longitudinal relaxation time as much as possible, and further, to lengthen the effective time of the contrast agent.

Besides, in this embodiment, the case where the gripper 207 for taking out the sample tube 301 from the cooling unit is provided at the gantry of the MRI apparatus is described, however, it is also possible to prepare the gripper 207 such as a robot arm separately from the MRI apparatus, and thereby take out the sample tube 301 and perform heating by the heating unit 307.

Further, Fig. 3 illustrates the DNP hyperpolarization device 300 with the microwave irradiating device 302 installed above the metal tube (waveguide) 303, however, the installed position of the microwave irradiating device 302 can be changed appropriately in accordance with the structure of the MRI apparatus, for example, in accordance with the distance between the upper and lower magnets. For example, as shown in Fig. 6, the microwave irradiating device 302 can be placed side by side with the cooling unit 304.

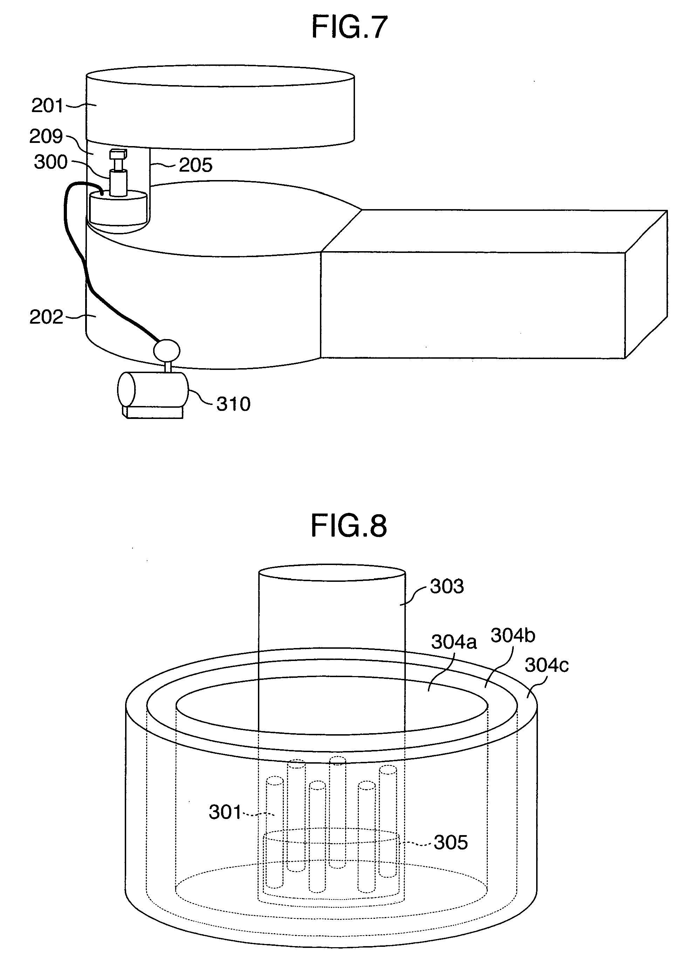

Next, a second embodiment of the present invention will be described. Fig. 7 is a drawing showing an appearance of an MRI apparatus according to the second embodiment of the present invention. Also in this embodiment, the internal construction is the same as that of the first embodiment shown in Fig. 2, and therefore, the explanation will be omitted.

This embodiment is characterized in that a housing chamber 209 for housing the DNP device 300 is formed in a space of the support column 205 connecting the upper magnet 201 and the lower magnet 202. In the case where a superconducting magnet is used as a static magnetic field generating magnet of the MRI apparatus, a connecting tube (including a heat shield plate) for connecting a cryostat of the upper magnet 2.01 and a cryostat of the lower magnet 202 passes through the support column 205, however, the housing chamber 209 can be provided by utilizing a space other than the connecting tube.

The construction of the DNP device 300 is the same as the first embodiment shown in Fig. 3, and the sample tube 301, the microwave irradiating device 302, the metal tube 303 and the cooling units 304a to 304c (including the sample holder) among the members constituting the DNP device 300 are made of a nonmagnetic material, and are integrally housed in the housing chamber 209. The vacuum bath 304b of the cooling unit is connected to the vacuum pump 310 which is placed exteriorly and kept at a predetermined vacuum degree.

In this embodiment, the DNP device 300 may be fixed to the housing chamber 209, but can be preferably taken out of the housing chamber 209 as needed to be operated. In that case, the base seat 204 can be used as with the first embodiment.

According to this embodiment, the DNP can be performed by utilizing the static magnetic field formed in the support column by the upper and the lower magnets. It is also possible to widely use the space inside the gantry for imaging.

Each embodiment of the MRI apparatus with the DNP means is described above, however, various modifications can be made for incorporating the DNP means into the MRI apparatus without being limited to the above described embodiment

One embodiment of such a modification is shown in Fig. 8. The embodiment shown in Fig. 8 is characterized in that a plurality of sample tube holders are provided in the metal tube 303 which confines a microwave therein to irradiating it to the sample, so that the samples housed in the plurality of sample tubes 301 can be hyperpolarized at one time. The RF transmitter coil 305 for cross polarization is provided to surround the plurality of sample tubes 301.

By providing a DNP device with a plurality of sample tubes, it becomes possible to continuously perform imaging using a 13C contrast agent, and thus to compensate the short relaxation time so as to perform the imaging in a broad area.

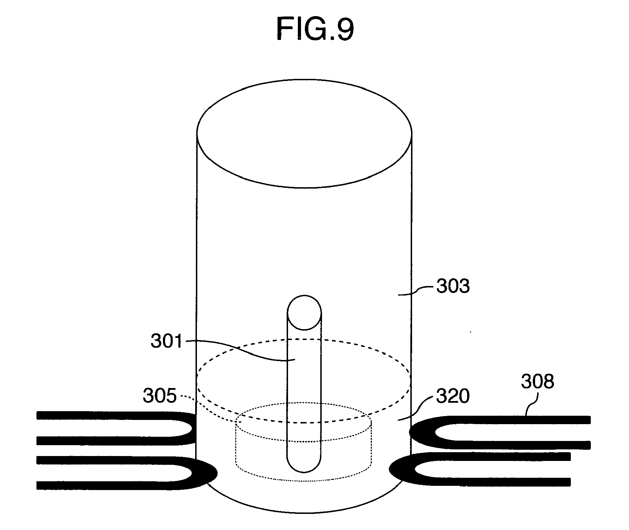

Another embodiment is shown in Fig. 9. The embodiment in Fig. 9 is characterized in that a gaseous refrigerant such as a low temperature helium gas is used as a cooling unit instead of liquid helium. Thus, in this embodiment, a sample tube holder 320, in which one or more holes for supporting a sample tube 301 are formed, is formed of a material with high thermal conductivity, for example, aluminum or the like. The RF transmitter coil 305 for cross polarization is built-in or housed in the sample tube holder 320, at a position surrounding the sample tube holder 320. The metal tube 303 is provided to cover the sample tube holder 320. Further, a passage 308 for helium gas is formed inside and/or on an outer periphery of the sample tube holder 320 to allow the helium gas to circulate therein. Especially by providing a refrigerant flow passage near the hole for supporting the sample tube 301, the sample inside the test tube 301 can be efficiently cooled, and the DNP can be effectively performed.

According to this embodiment, since the liquid helium is not used, the device can be made compact, and the installation into the MRI apparatus and the incorporation into the support column are made easier.

Again, it should be further understood by those skilled in the art that although the foregoing description has been made on embodiments of the invention, the invention is not limited thereto and various changes and modifications may be made without departing from the spirit of the invention and the scope of the appended claims.

## Claims

1. A magnetic resonance imaging apparatus comprising:
a static magnetic field generating means for generating a static magnetic field in a space where a subject is to be placed;
a magnetic field gradient generating means for generating a magnetic field gradient in the space;
a transmitter means for applying a radio magnetic field to the subject;
a receiver means for detecting a magnetic resonance signal generated from the subject;
a signal processing means for reconstructing an image of the subject by using the magnetic resonance signal; and
a hyperpolarization means for performing hyperpolarization processing of a substance to be injected into the subject, wherein
the hyperpolarization means comprises a sample tube in which a sample is placed, a cooling unit for cooling and solidifying the sample in the sample tube, a magnetic field applying means for applying a magnetic field to the sample, and a microwave irradiating unit for irradiating a microwave to the sample, and the magnetic field applying means is said static magnetic field generating means.

2. The magnetic resonance imaging apparatus according to claim 1, further comprising a means for installing the microwave irradiating unit, the sample tube and the cooling unit as an integral part in the static magnetic field space generated by the static magnetic field generating means.

3. The magnetic resonance imaging apparatus according to claim 1 or 2, wherein at least a member placed in the static magnetic field space among members of the hyperpolarization means is formed of a nonmagnetic material.

4. The magnetic resonance imaging apparatus according to any one of claims 1-3, further comprising a means for picking up the sample tube from the hyperpolarization means and gripping the sample tube.

5. The magnetic resonance imaging apparatus according to any one of claims 1-4, wherein the hyperpolarization means comprises a plurality of sample tubes.

6. The magnetic resonance imaging apparatus according to any one of claims 1-5, wherein the cooling unit comprises a sample tube supporting member made of a high thermal conductive material, and a gas passage formed inside and on an outer periphery of the supporting member for circulating a helium gas supplied from a helium gas supply source.
